Europäisches Patentamt

European Patent Office

Office européen des brevets

(19)

(11) **EP 0 785 571 B1**

(12) **EUROPEAN PATENT SPECIFICATION**

(45) Date of publication and mention
of the grant of the patent:
**18.10.2000 Bulletin 2000/42**

(51) Int Cl.⁷: **G03F 7/20**

(21) Application number: **96309565.8**

(22) Date of filing: **31.12.1996**

(54) **Exposure method and apparatus therefore**

Belichtungsverfahren und Belichtungsvorrichtung

Méthode et appareil d'exposition

(84) Designated Contracting States:
**DE GB NL**

(30) Priority: **08.01.1996 JP 1698596**
**08.01.1996 JP 1698696**
**06.12.1996 JP 34044596**

(43) Date of publication of application:
**23.07.1997 Bulletin 1997/30**

(73) Proprietor: **CANON KABUSHIKI KAISHA
Tokyo (JP)**

(72) Inventor: **Morisada, Masahiro
Ohta-ku, Tokyo (JP)**

(74) Representative: **Beresford, Keith Denis Lewis
BERESFORD & Co.
High Holborn
2-5 Warwick Court
London WC1R 5DJ (GB)**

(56) References cited:
**US-A- 4 023 126        US-A- 5 285 236**

**Description**

This invention relates to a step-and-scan type semiconductor exposure apparatus wherein scan operation with exposure process and step operation without exposure process are performed alternately. More particularly, the invention is concerned with improvements in an X-Y stage control device for controlling an X-Y stage of such exposure apparatus.

Generally, scan type semiconductor exposure apparatuses use an X-Y stage for controlling the exposure position on a wafer with respect to a predetermined location. Scan operation period with exposure process includes an acceleration period, a deceleration period and a constant-speed period. The constant-speed period consists of an exposure period and a constant-speed idle period necessary for acceleration stabilization. Step operation period without exposure process includes an acceleration period, a deceleration period and a constant-speed period. As regards the X-Y stage control, if the X-Y stage is decelerated and stopped in transition from the scan operation to the step operation or from the step operation to the scan operation, then it takes a long time to complete the exposure of a wafer as a whole.

It is an object of the present invention to provide an exposure method or apparatus by which the overall time necessary for performing pattern transfer to the whole surface of a wafer through a step-and-scan procedure can be reduced considerably to thereby increase the throughput effectively.

It is another object of the present invention to provide an improved device manufacturing method, based on such exposure method or apparatus above, by which a higher productivity is assured.

In accordance with an aspect of the present invention, there is provided an exposure method, comprising the steps of: transferring a pattern of a mask on to different zones on a wafer through a combination of a first operation wherein the wafer is scanningly moved in a predetermined direction for scan exposure of the same and a second operation wherein the wafer is moved stepwise in a direction different from the predetermined direction; and before motion of one of the first and second operations is stopped, initiating motion of the other operation.

In one preferred form of this aspect of the present invention, wherein both of the mask and the wafer are scanningly moved by which the mask pattern is transferred on to one zone on the wafer.

In another preferred form of this aspect of the present invention, the method further comprises projecting slit light on to the mask, scanningly moving the mask and the wafer in a timed relation and at a predetermined speed ratio, and projecting the mask pattern on to the wafer in a reduced scale, whereby the mask pattern is transferred on to the wafer in a reduced scale.

In a further preferred form of this aspect of the present invention, as scan motion in the predetermined direction passes an exposure completion position, acceleration of a subsequent stepwise motion is initiated.

In a further preferred form of this aspect of the present invention, after scan motion in the predetermined direction passes an exposure completion position and before deceleration is initiated, acceleration of a subsequent stepwise motion is initiated.

In a further preferred form of this aspect of the present invention, when an n-th operation period for the wafer comprises a scan motion period, an (n+1)-th operation period comprises a stepwise motion period and an (n+2)-th operation period comprises a scan motion period, acceleration in the (n+1)-th motion period is initiated as an exposure completion position in the n-th operation period is passed and then acceleration in the (n+2)-th operation period is initiated after deceleration in the n-th operation period is completed.

In a further preferred form of this aspect of the present invention, acceleration in the (n+2)-th operation period is initiated before deceleration of stepwise motion in the (n+1)-th operation period is initiated.

In a further preferred form of this aspect of the present invention, the timing for initiation of motion of the other operation is variable.

In a further preferred form of this aspect of the present invention, the timing is variably set in accordance with at least one of target acceleration and jerk of the scan motion or of the stepwise motion, speed of constant-speed scan, and acceleration stabilization time.

In accordance with another aspect of the present invention, there is provided a device manufacturing method which includes an exposure method as described above.

In accordance with a further aspect of the present invention, there is provided an exposure apparatus, comprising: illumination means for illuminating a predetermined illumination region on a mask; a mask stage for holding the mask and for scanningly moving the same; a projection optical system for projecting a pattern of the mask on to a wafer; a wafer stage for holding the wafer and for moving the same; and control means serviceable to perform step-and-scan operation wherein said mask stage and said wafer stage are scanningly moved in a timed relation and at a predetermined speed ratio to scanningly expose the wafer to the pattern of the mask and wherein said wafer stage is moved stepwise to change a scanning exposure region on the wafer, said control means further being serviceable in the step-and-scan operation such that, before one of the scan motion and the stepwise motion is stopped, the other motion is initiated.

Embodiments of the present invention will now be described with reference to the accompanying drawings, in which:

Figure 1 is a schematic view of general structure of a scan type semiconductor exposure apparatus.

Figure 2 is a schematic view for explaining locus of movement of slit light on a wafer, as viewed from the above.

Figure 3 is a block diagram of an X-Y stage control system in accordance with a first embodiment of the present invention.

Figure 4 is a graph for explaining a target value pattern as produced by an X-axis position target generating means an a Y-axis position target generating means of the system of Figure 3.

Figure 5 is a graph for explaining another example of target value pattern as produced by an X-axis position target generating means an a Y-axis position target generating means of the system of Figure 3.

Figure 6 is a graph for explaining changes in X-axis speed and Y-axis speed in the system of Figure 3.

Figure 7 is a flow chart for explaining operation algorithm of a locus complementing means of the system of Figure 3.

Figure 8 is a flow chart for explaining operation algorithm of a locus complementing means of an X-Y stage control system according to a second embodiment of the present invention.

Figure 9 is a graph for explaining motion of an X-Y stage, along an X-Y plane, of the system of Figure 3.

Figure 10 is a graph for explaining motion of an X-Y stage, along an X-Y plane, of the system of the Figure 8 embodiment.

Figure 11 is a graph for explaining another example of motion of an X-Y stage, along an X-Y plane, of the system of the Figure 8 embodiment.

Figure 12 is a block diagram of an X-Y stage control system in accordance with a third embodiment of the present invention.

Figure 13 is a flow chart for explaining operation algorithm of a complementing process setting means of the system of Figure 12.

Figure 14 is a flow chart for explaining algorithm A1 in the flow chart of Figure 13.

Figure 15 is a flow chart for explaining algorithm A2 in the flow chart of Figure 13.

Figure 16 is a flow chart for explaining algorithm A3 in the flow chart of Figure 13.

Figure 17 is a graph for explaining motion of a certain point of an X-Y stage along an X-Y plane, as algorithm A3 of Figure 16 is selected.

Figure 18 is a graph for explaining motion of a certain point of an X-Y stage along an X-Y plane, as algorithm A2 of Figure 16 is selected.

Figure 19 is a graph for explaining motion of a certain point of an X-Y stage along an X-Y plane, as algorithm A3 of Figure 16 is selected.

Figure 20 is a flow chart for explaining operation algorithm of a locus complementing means of an X-Y stage control system according to a fourth embodiment of the present invention.

Figure 21 is a graph for explaining motion of an X-Y stage, along an X-Y plane, of the system of Figure 20.

Figure 22 is a flow chart of semiconductor device manufacturing processes.

Figure 23 is a flow chart of a wafer process.

The invention will be described in detail with reference to preferred embodiments thereof. Scan type exposure apparatus is a step-and-scan type exposure apparatus wherein a portion of a pattern, formed on a reticle (original), is projected on to a semiconductor wafer in a reduced scale while the reticle and the wafer are scanningly moved in synchronism with each other along a plane of projection, by which the whole pattern of the reticle is lithographically transferred on to one zone on the wafer; after that, the wafer is moved stepwise and the exposure process is performed to another zone; the scan exposure of the above procedure being repeated by which reticle patterns are printed on the whole surface of the wafer in array.

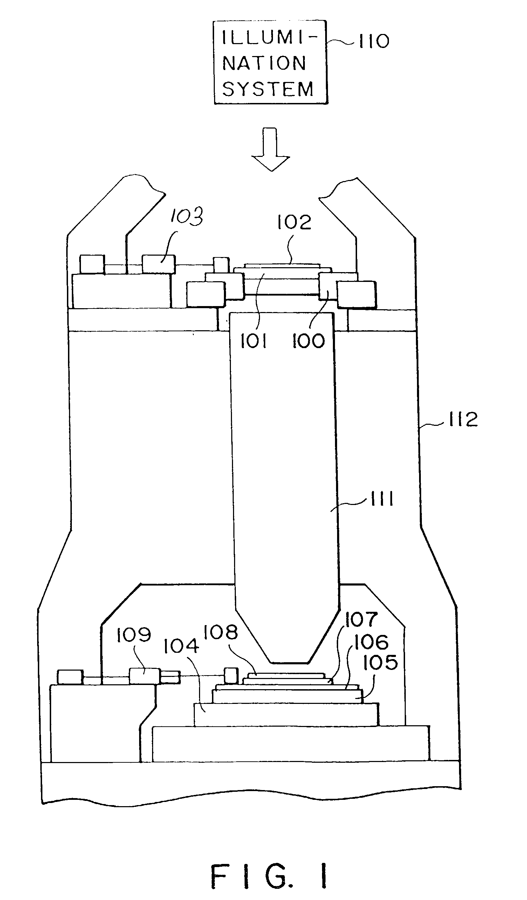

Figure 1 illustrates general structure of a scan type exposure apparatus. Denoted in the drawing at 100 is a reticle stage having a reticle chuck 101 for holding a reticle 102. The reticle stage 100 is movable in one direction (X direction) for scan motion. There is a laser interferometer 103 for monitoring motion of the reticle stage.

Associated wafer stage is placed on a base 104, and it includes a Y stage 105 and an X stage 106. Wafer chuck 107 on the wafer stage holds a wafer 108. The wafer stage is movable in two directions (X and Y directions). There is a laser interferometer 109 for monitoring motion of the wafer stage.

Denoted at 110 is an illumination means which comprises a light source and an illumination optical system, for example. It serves to illuminate the reticle 102 with elongated slit light, in a direction (Y direction) orthogonal to the scan direction of the reticle stage. Denoted at 111 is a reduction optical system for projecting a pattern of the reticle 102 on to the wafer 108 in a reduced scale of 4:1. Denoted at 112 is a frame for holding the reticle stage 100, the wafer stage 104 and the reduction projection optical system 111.

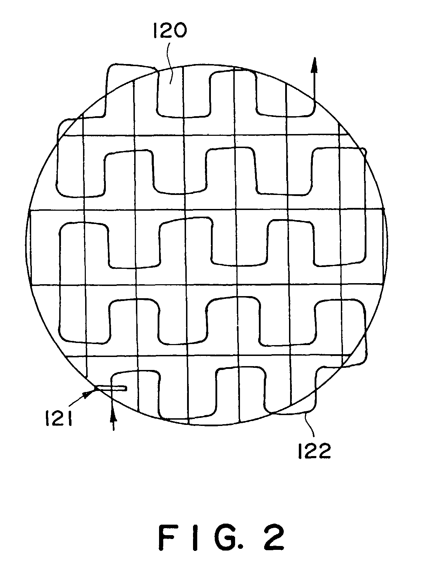

Figure 2 illustrates sequence of step-and-scan procedure to different (split) zones on a wafer 120. By means of the wafer stage, the wafer 120 is step-and-scan moved relatively to a fixed illumination slit light 121, so that the slit light 121 moves across each zone on the wafer 120 along a movement locus 122 as illustrated.

[Embodiment 1]

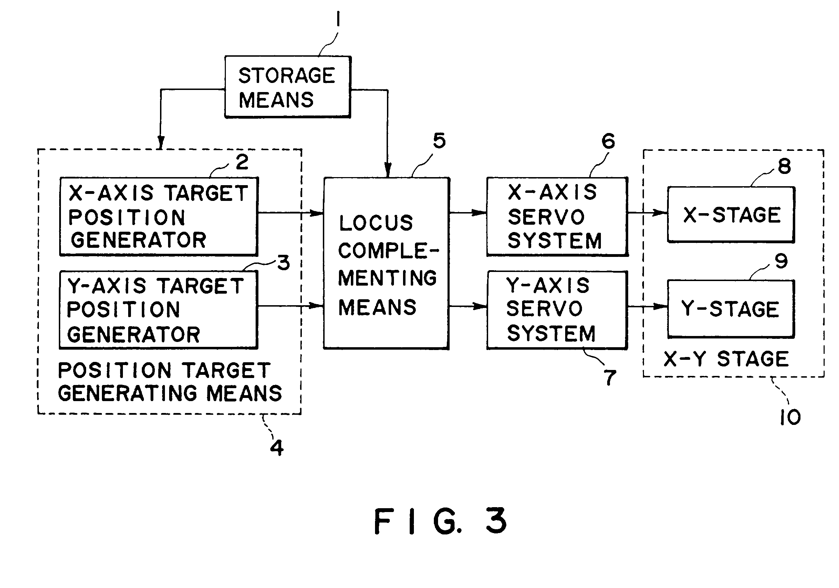

Figure 3 is a block diagram of an X-Y stage control system of a wafer stage, for a scan type exposure apparatus such as described above. Denoted in the drawing at 1 is a storage means for storing therein a target acceleration, a target speed, a target position, an exposure start position, an exposure completion position, and the like. Denoted at 2 is an X-axis position target generating means for producing a position target value for X axis. Denoted at 3 is a Y-axis position target generating means for producing a position target value for Y axis. Denoted at 4 is a position target generating means which comprises the X-axis position target generating means 2 and the Y-axis position target generating means 3. Denoted at 5 is a locus complementing means for applying position target values produced by the X-axis and Y-axis position target generating means 2 and 3, to an X-axis servo system 6 and a Y-axis servo system 7, respectively, as position designation signal. The X-axis servo system 6 serves to perform drive of X-stage 8 so as to follow the X-axis position designation signal, and the Y-axis servo system 7 serves to perform drive of Y stage 9 so as to follow the Y-axis position designation signal. The X stage denoted at 8 is a subject of drive, and the Y stage denoted at 9 is also a subject of drive. Denoted at 10 is an X-Y stage which comprises the X stage 8 and the Y stage 9.
Operation of the X-Y stage control system of the structure described above, will be explained. The X-axis position target generating means 2 calculates an X-axis position target value $x_r$ on the basis of a target acceleration, a target speed, an X-axis target position and an X-axis movement start position, as stored in the storage means 1, and in accordance with equation (1) below:

$$
\begin{cases}
x_r = x_r^0 + (1/2)a_r t^2 & \cdot\ \ 0 \le t \le t_1 \\
x_r = x_r^0 + (1/2)a_r t_1^2 + v_r(t - t_1) & t_1 \le t \le T - t_1 \\
x_r = x_r^T - (1/2)a_r(T - t)^2 & T - t_1 \le t \le T
\end{cases}
$$

$$\ldots (1)$$

where $t_1 = v_r/a_r$, $T = t_1 + (x_r^T - x_r^0)/v_r$, $a_r$ is a target maximum acceleration, $v_r$ is a target maximum speed, $x_r^0$ is an X-axis drive start position, $x_r^T$ is an X-axis target position, and t is the time moment as the operation start moment is taken as 0 (zero).
Similarly to the X-axis position target generating means 2, the Y-axis position target generating means 3 calculates a Y-axis position target value $y_r$ in accordance with equation (2) below:

$$
\begin{cases}
y_r = y_r^0 + (1/2)a_r t^2 & 0 \le t \le t_1 \\
y_r = y_r^0 + (1/2)a_r t_1^2 + v_r(t - t_1) & t_1 \le t \le T - t_1 \\
y_r = y_r^T - (1/2)a_r(T - t)^2 & T - t_1 \le t \le T
\end{cases}
$$

$$\ldots (2)$$

where $y_r^0$ is a Y-axis drive start position and $y_r$ is a Y-axis target position.

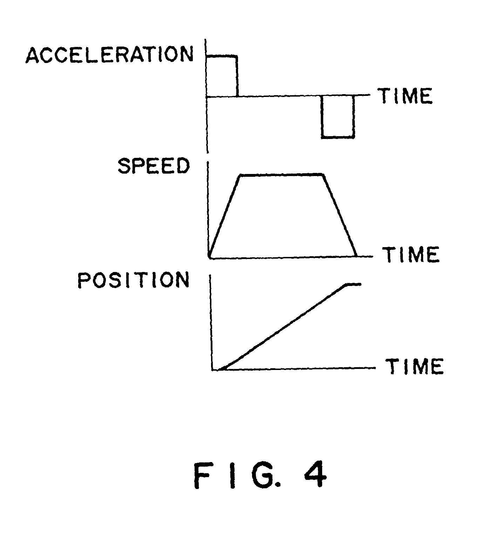

Figure 4 shows a position target value of a trapezoidal speed pattern as generated by the position target generating means 4, in which both of speed component and acceleration component of the position target value pattern are illustrated.
The X-axis servo system 6 controls the X stage 8 so that it follows an X-axis position designated value (position target value) provided by the locus complementing means 5. The Y-axis servo system 7 controls the Y stage 9 so that it follows a Y-axis position designated value provided by the locus complementing means 5. Consequently, the X-Y stage as a whole can be moved to a desired position along the X-Y plane. The locus complementing means 5 picks up pieces of target position data, one by one, out of target position data trains as stored in the storage means 1, and applies them to the position target generating means 4 as parameters. Through repetition of picking up the target position data out of the storage means 1, the wafer as a whole is scanned.

In this embodiment, in the scan operation period the X-Y stage 10 is moved in the X-axis direction and, in the step operation period, the X-Y stage 10 is moved in the Y-axis direction. This may be reversed so that the X-Y stage 10 is moved in the Y-axis direction in the scan operation period and is moved in the X-axis direction in the step operation period. With regard to the axis which is orthogonal to the operation direction, control is performed to maintain a constant position.

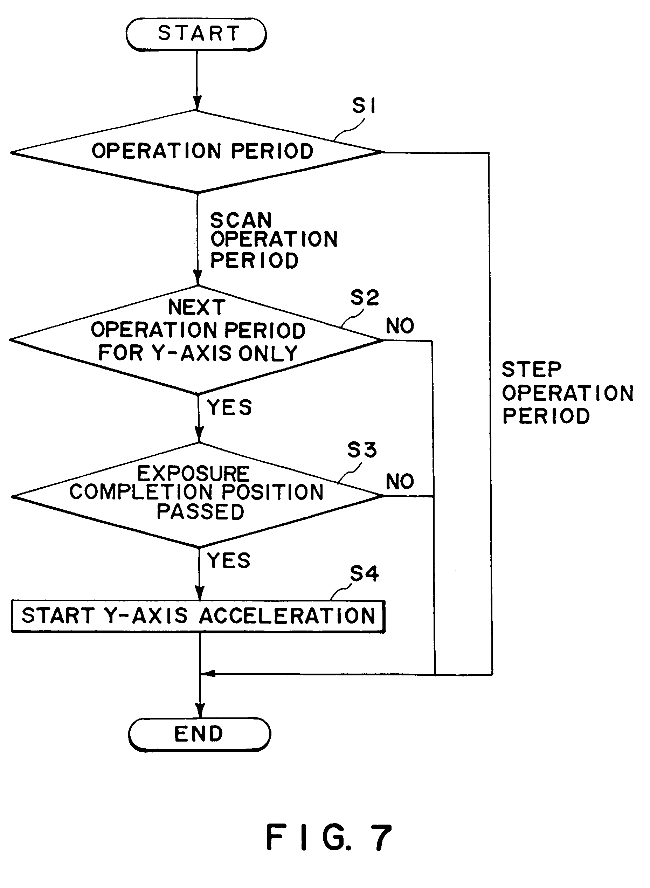

Figure 7 is a flow chart for explaining operation algorithm of the locus complementing means 5. First, the locus complementing means 5 performs discrimination on the basis of the target position data stored in the storage means 1, as to whether the current operation period is a scan operation period; whether the subsequent operation period is only for the Y axis; and whether the X-Y stage has passed an exposure completion position corresponding to one chip pattern (steps S1 - S3). If the result of discrimination shows truth, in regard to the subsequent operation period the Y-axis position target generating means 3 is actuated to start Y-axis acceleration (step S4). If the result of discrimination shows falsehood, the position target generated by the X-axis position target generating means 2 is applied to the X-axis servo system 6 and constant-speed X-axis drive is continued until the target position is reached. If both axes are in operation in the current operation period, it is concluded that the X-Y stage 10 has reached the target position, and the drive of that axis is continued till the end of the current operation period. The position target generating means 4 and the locus complementing means 5 may be realized by an algorithm of a central processing unit.

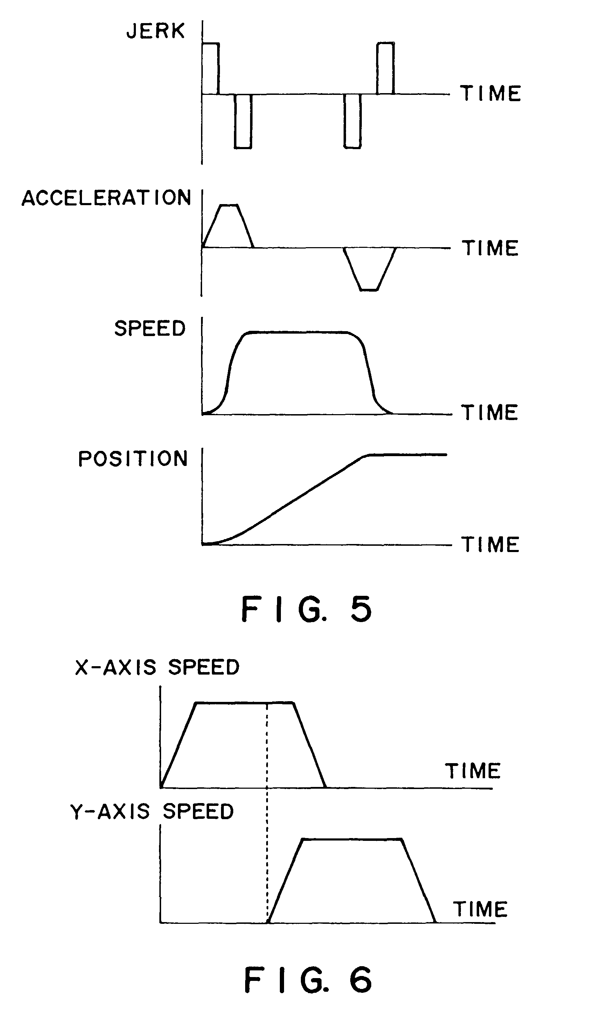

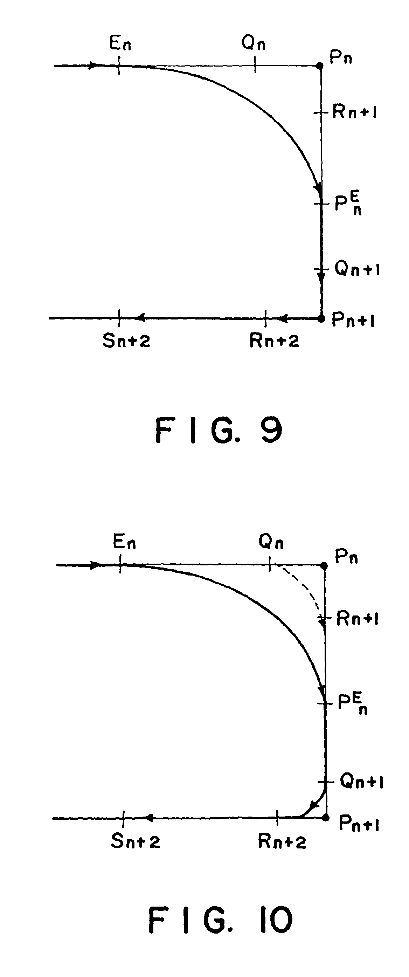

Figure 6 shows an example and illustrates changes in X-axis speed and Y-axis speed in an occasion where the current operation period is a scan operation period and the subsequent operation axis is Y axis only. Viewing motion of a certain point on the X-Y stage 10 along the X-Y plane, the result may be such as illustrated in Figure 9. In the drawing, $P_n$ and $P_{n+1}$ denote target positions in the n-th operation period and (n+1)-th operation period, respectively, and $Q_n$ and $Q_{(n+1)}$ denote deceleration start positions in the n-th operation period and (n+1)-th operation period, respectively. $E_n$ denotes an exposure completion position in the n-th operation period. $R_{n+1}$ and $R_{n+2}$ denoted acceleration completion positions in the (n+1)-th operation period and (n+2)-th operation period, respectively, and $S_{n+2}$ denotes an exposure start position in the (n+2)-th operation period. The X-Y stage 10 does not stop at point $P_n$ but passes inside the apical angle smoothly. This is effective to reduce the total time necessary for the step-and-scan operation to the whole wafer surface, and is effective to improve the throughput.

[Embodiment 2]

This embodiment differs from the first embodiment only in the point of operation algorithm of the locus complementing means 5. Thus, description will be made here only to the locus complementing means 5.

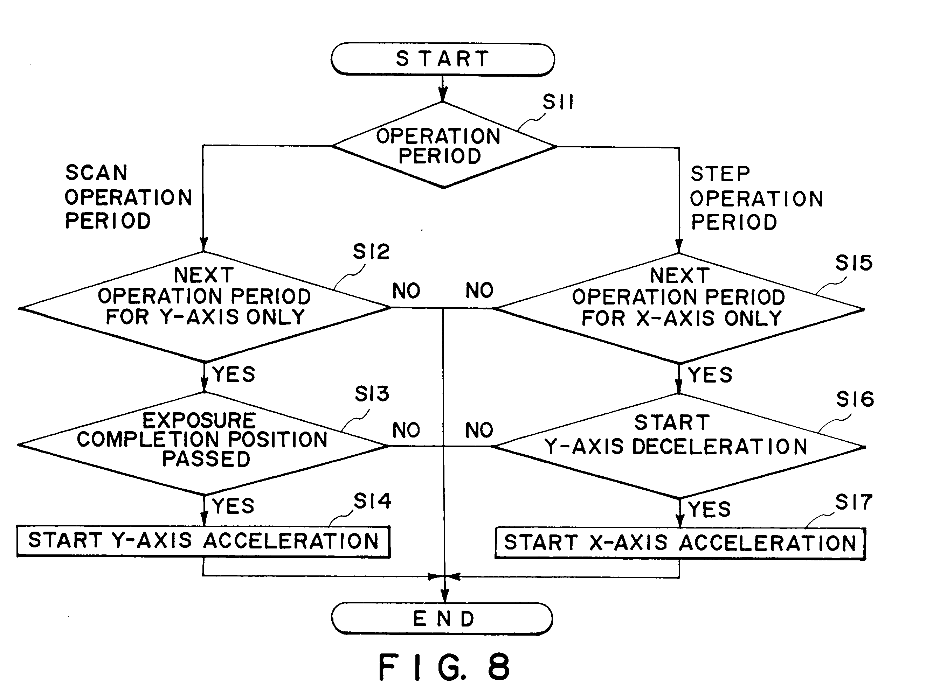

Figure 8 is a flow chart for explaining operation algorithm of the locus complementing means 5 in an X-Y stage control system according to the second embodiment of the present invention. On the basis of target position data stored in the storage means 1, the locus complementing means performs discrimination as to: whether the current operation period is a scan operation period; whether only the Y axis is in operation in the subsequent operation period; and whether the X-Y stage has passed an exposure completion position corresponding to one chip pattern (steps S11 - S13). If the result of discrimination shows truth, in regard to the subsequent operation period the Y-axis position target generating means 3 is actuated to initiate Y-axis acceleration (step S14). Also, the locus complementing means 5 performs discrimination as to: whether the current operation period is a step operation period; whether only the X axis is in operation in the subsequent operation period; and whether Y-axis deceleration has started (steps S15 - S16). If the result of discrimination shows truth, in regard to the subsequent operation period the X-axis position target generating means 2 is actuated to start X-axis acceleration (step S17). If the results of both of these discriminations show falsehood, drive is continued until the target position is reached and the current operation period is completed. If both axes are in operation in the current operation period, it is concluded that the X-Y stage 10 has reached the target position, and the drive of that axis is continued till the end of the current operation period. The position target generating means 4 and the locus complementing means 5 may be realized by an algorithm of a central processing unit.

Viewing motion of a certain point on the X-Y stage 10 along the X-Y plane, the result may be such as illustrated in Figure 10. Reference characters in the drawing similar to those of Figure 9 represent corresponding positions. The X-Y stage 10 does not stop at point $P_n$ or $P_{n+1}$ but it passes inside the apical angle smoothly. This is effective to reduce the total time necessary for the step-and-scan operation to the whole wafer surface, much more than in the first embodiment.

As an alternative, acceleration in the step motion may be initiated after start of deceleration (Qn) in the scan operation period, as depicted by a broken line in Figure 10.

In the first and second embodiments, a target value which can be called a trapezoidal speed pattern such as shown in Figure 4 is generated. However, a target value of such pattern as shown in Figure 5 may be generated, this being effective to assure more smooth motion and less vibration of X-Y stage 10.

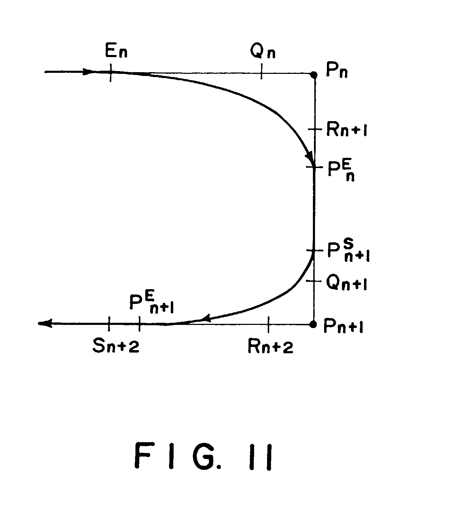

Also, as shown in Figure 11, after completion of exposure in the current scan operation period and before start of deceleration in the current scan operation period, acceleration in the subsequent step operation period may be initiated. In Figure 11, $PE_n$ and $PE_{n+1}$ denote deceleration completion positions in the n-th operation period and (n+1)-th operation period, and $PS_{n+1}$ denotes X-axis acceleration start position. In this occasion, the X-Y stage 10 does not stop at $P_n$ or $P_{n+1}$ but it passes inside the apical angle smoothly along a curve. Point $PS_{n+1}$ may be predetermined so that X-axis control deviation of the X-Y stage is stabilized or regulated between $PE_{n+1}$ and $S_{n+2}$.

[Embodiment 3]

In the example shown in Figure 11, if acceleration or jerk in a deceleration period of step operation is made large, there is a possibility that the exposure period is reached before the positional error in the direction of step motion is stabilized or regulated, causing defective exposure. If the constant-speed idle period for stabilization is made longer in order to avoid this problem, it is possible that in an end portion of the wafer a target position of the Y-Y stage goes out of the movable range.

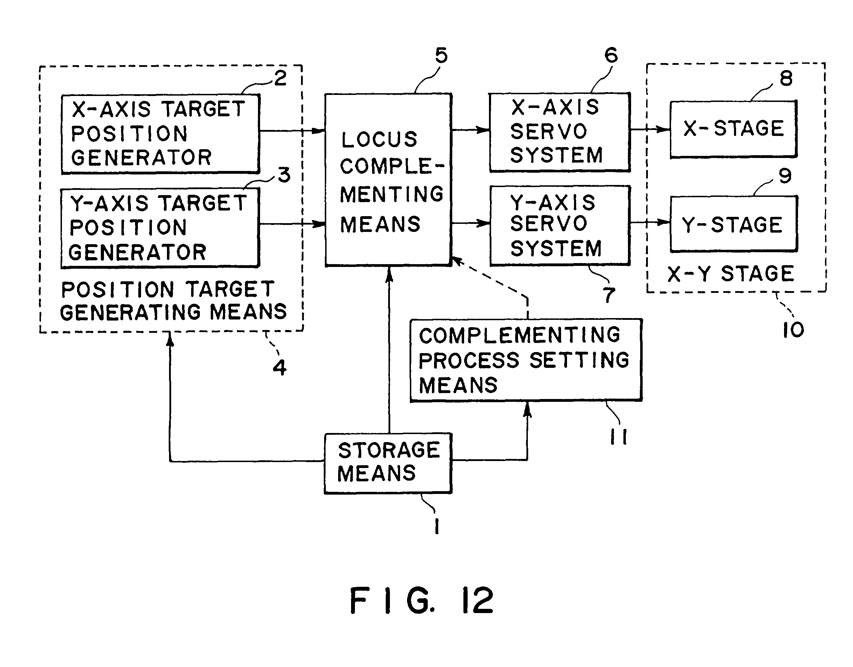

Figure 12 is a block diagram of an X-Y stage control system of a scan type semiconductor exposure apparatus according to a third embodiment of the present invention, by which the above-described problem is solved. As compared with the embodiment of Figure 3, there is a complementing process determining means 11 added. The complementing process determining means 11 serves to determine a locus complementing process in the locus complementing means 5. Thus, in accordance with the complementing process as determined by the complementing process determining means 11, the locus complementing means 5 produces and applies position designated values to the X-axis and Y-axis servo systems 6 and 7. The remaining portion of this embodiment is essentially the same as the Figure 3 embodiment.

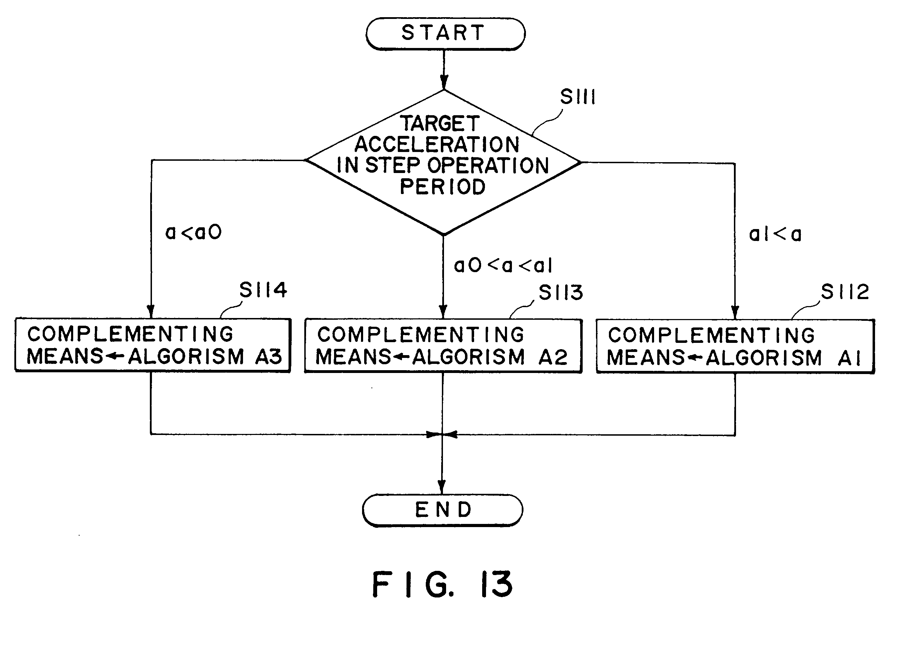

Figure 13 is a flow chart for explaining operation algorithm of the complementing process determining means 11. As illustrated, the complementing process determining means 11 performs discrimination about the target acceleration $\underline{a}$ of the step operation period: in which one of ranges a>a1, a0<a<a1 and a<a0 the acceleration is (step S111). If it is in the range a>a1, algorithm A1 to be described is selected as the complementing process (step S112). If it is in the range a0<a<a1, algorithm A2 is selected as the complementing process (step S113). If it is in the range a<a0, algorithm A3 is selected as the complementing process (step S114). Here, a0 and a1 are thresholds predetermined.

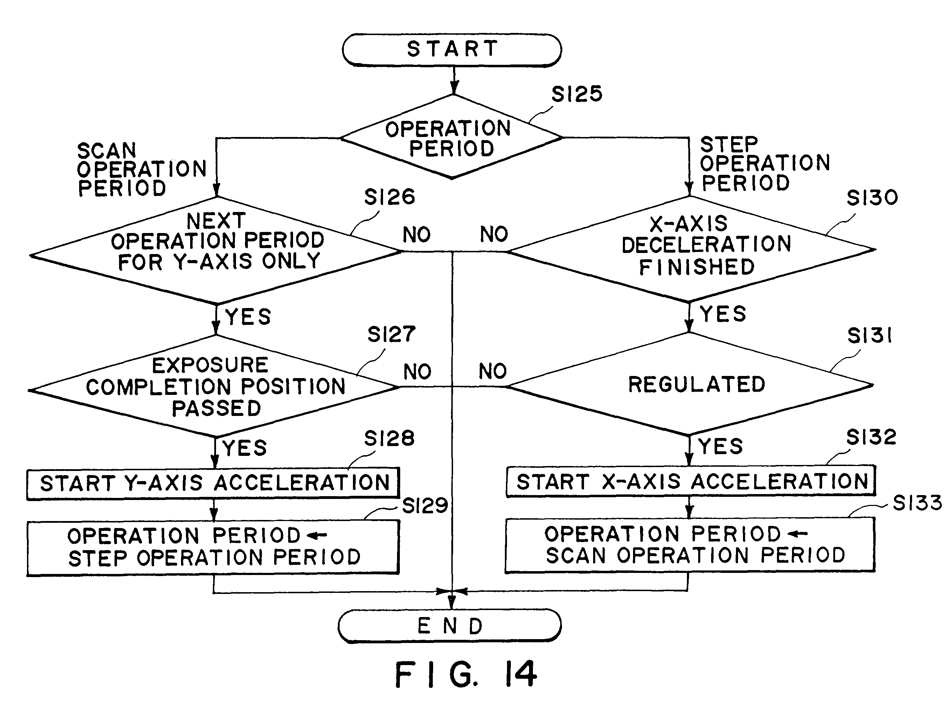

Figure 14 is a flow chart for explaining algorithm A1. First, the locus complementing means 5 performs discrimination on the basis of the target position data stored in the storage means 1 as to: whether the current operation period is a scan operation period; whether only Y axis is in operation in the subsequent operation period; and whether the X-Y stage has passed an exposure completion position (steps S125 - S127). If the result of discrimination shows truth, in regard to the subsequent operation period the Y-axis position target generating means 3 is actuated to initiate Y-axis acceleration, and the procedure goes to the step operation period (steps S128 and S129). Also, the locus complementing means 5 performs discrimination as to: whether the current operation period is a step operation period; whether X-axis deceleration has completed; and whether X-axis positional error has been stabilized or regulated (steps S125, S130 and S131). If the result of discrimination shows truth, in regard to the subsequent operation period the X-axis position target generating means 2 is actuated to start X-axis acceleration, and the procedure goes to a scan operation period (steps S132 and S133). If the results of all discriminations show falsehood, drive is continued until the target position is reached and the current operation period is completed. If both axes are in operation in the current operation period, it is concluded that the X-Y stage has reached the target position, and drive for the axis is continued until the current operation period is completed.

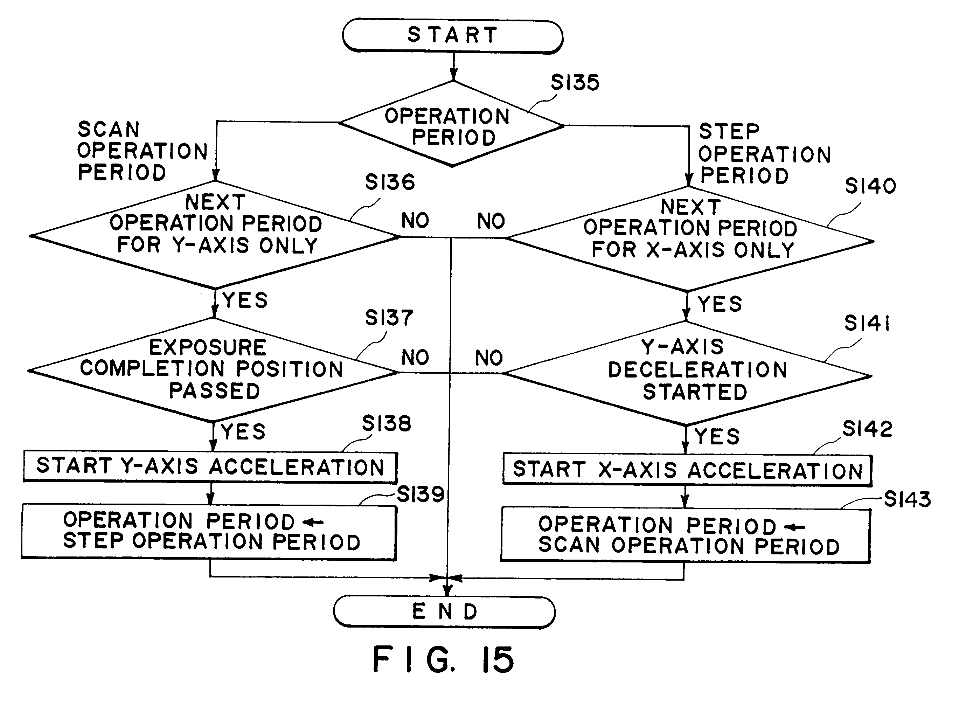

Figure 15 is a flow chart for explaining algorithm A2. First, the locus complementing means 5 performs discrimination on the basis of the target position data stored in the storage means 1 as to: whether the current operation period is a scan operation period; whether only Y axis is in operation in the subsequent operation period; and whether the X-Y stage has passed an exposure completion position (steps S135 - S137). If the result of discrimination shows truth, in regard to the subsequent operation period the Y-axis position target generating means 3 is actuated to initiate Y-axis acceleration, and the procedure goes to the step operation period (steps S138 and S139). Also, the locus complementing means 5 performs discrimination as to: whether the current operation period is a step operation period; whether only X axis is in operation in the subsequent operation period; and whether Y-axis deceleration has been started (steps S135, S140 and S141). If the result of discrimination shows truth, in regard to the subsequent operation period the X-axis position target generating means 2 is actuated to start X-axis acceleration, and the procedure goes to a scan operation period (steps S142 and S143). If the results of all discriminations show falsehood, drive is continued until the target position is reached and the current operation period is completed. If both axes are in operation in the current operation period, it is concluded that the X-Y stage has reached the target position, and drive for the axis is continued until the current operation period is completed.

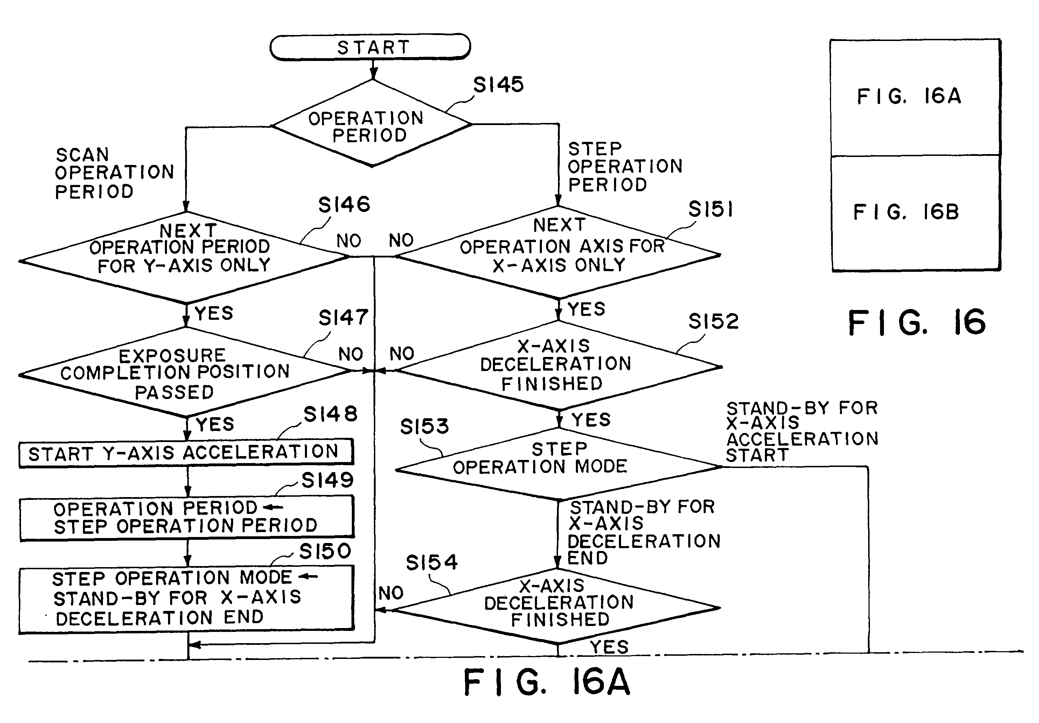

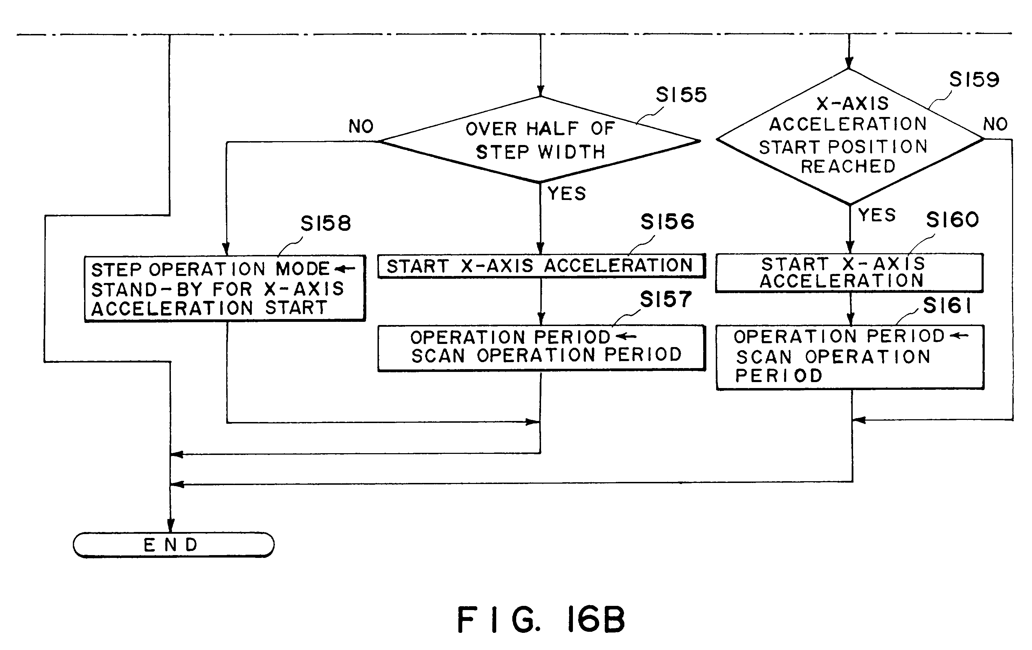

Figure 16 is a flow chart for explaining algorithm A3. First, the locus complementing means 5 performs discrimination on the basis of the target position data stored in the storage means 1 as to: whether the current operation period is a scan operation period; whether only Y axis is in operation in the subsequent operation period; and whether the X-Y stage has passed an exposure completion position (steps S145 - S147). If the result of discrimination shows truth, in regard to the subsequent operation period the Y-axis position target generating means 3 is actuated to initiate Y-axis acceleration, and the procedure goes to the step operation period and to the step operation mode, waiting for completion of X-axis deceleration (steps S148 - S150). Also, the locus complementing means 5 performs discrimination as to: whether the current operation period is a step operation period; whether only X axis is in operation in the subsequent operation period; and whether X-axis deceleration has completed (steps S145, S151 and S152). If the result of discrimination shows truth, then discrimination is made as to whether the current step operation mode is one waiting for completion of X-axis deceleration or one waiting for start of X-axis acceleration (step S153).

If the result of discrimination at step S153 shows that is is the one waiting for completion of X-axis deceleration, further discrimination is made as to whether, at the moment of completion of X-axis deceleration, a middle position of the step width of the step operation period has passed (steps S154 and S155). If the result of discrimination shows truth, the X-axis position target generating means 2 is actuated to start X-axis acceleration, and the procedure goes to a scan operation period (steps S156 and S157). If the result discrimination at step S155 shows falsehood, the procedure goes to a step operation mode, waiting for start of X-axis acceleration (step S158).

If the result of discrimination at step S153 shows that it is the one waiting for start of X-axis acceleration, further discrimination is made as to whether a predetermined X-axis acceleration start position has reached or not (step S159). If the result of discrimination at step S159 shows truth, the X-axis position target generating means 2 is actuated to start X-axis acceleration, and procedure goes to a scan operation period (steps S160 and S161). If both axes are in operation in the current operation period, it is concluded that the X-Y stage has reached the target position, and drive for the axis is continued until the current operation period is completed. The position target generating means 4, the locus complementing means 5 and the complementing process setting means 11 may be realized by algorithm of a central processing unit, not shown.

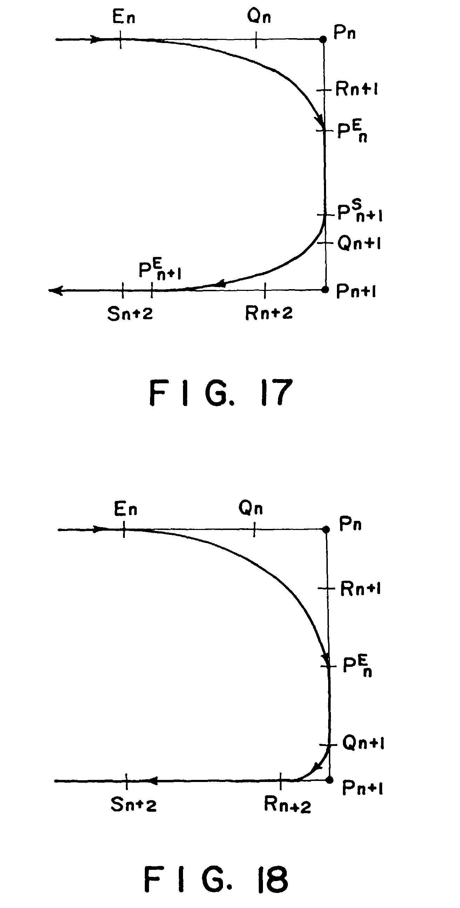

Figure 17 illustrates a movement locus of a certain point on the X-Y stage 11 along the X-Y plane, as algorithm A3 is selected. The portion from the n-th operation period to the (n+2)-th operation period is illustrated, wherein the n-th operation period and the (n+2)-th operation period are scan operation periods, and the (n+1)-th operation period is a step operation period. Reference characters in Figure 17 similar to those of Figure 11 represent corresponding positions. In this case, the X-Y stage 10 does not stop at $P_n$ or $P_{n+1}$ but it passes inside the apical angle smoothly. Point $PS_{n+1}$ may be predetermined so that X-axis control deviation of the X-Y stage is stabilized or regulated between $PE_{n+1}$ and $S_{n+2}$.

Figure 18 illustrates motion of a certain point on the X-Y stage 10 along the X-Y plane, as algorithm A2 is selected.

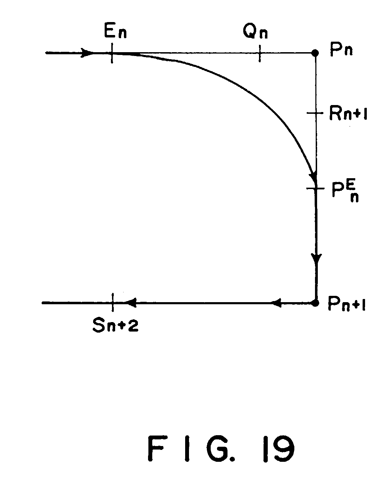

Figure 19 illustrates motion of a certain point on the X-Y stage 11, as algorithm A1 is selected. Since $P_{n+1}$ is given as a target position until the Y-axis positional error is stabilized or regulated, the X-Y stage 10 once stops at $P_{n+1}$.

With this procedure, even if acceleration in the step operation period is changed, stabilization or regulation of positional error in the direction of step motion can be assuredly performed before the exposure process in the subsequent scan operation starts. Thus, correct and accurate scan exposure process is assured.

Also in the present embodiment, a target value of a pattern such as shown in Figure 5 may be generated, by which more smooth motion and less vibration of X-Y stage 10 are enabled. In that occasion, since the jerk has a finite value, the value of jerk may be taken as a condition in setting the complementing process.

[Embodiment 4]

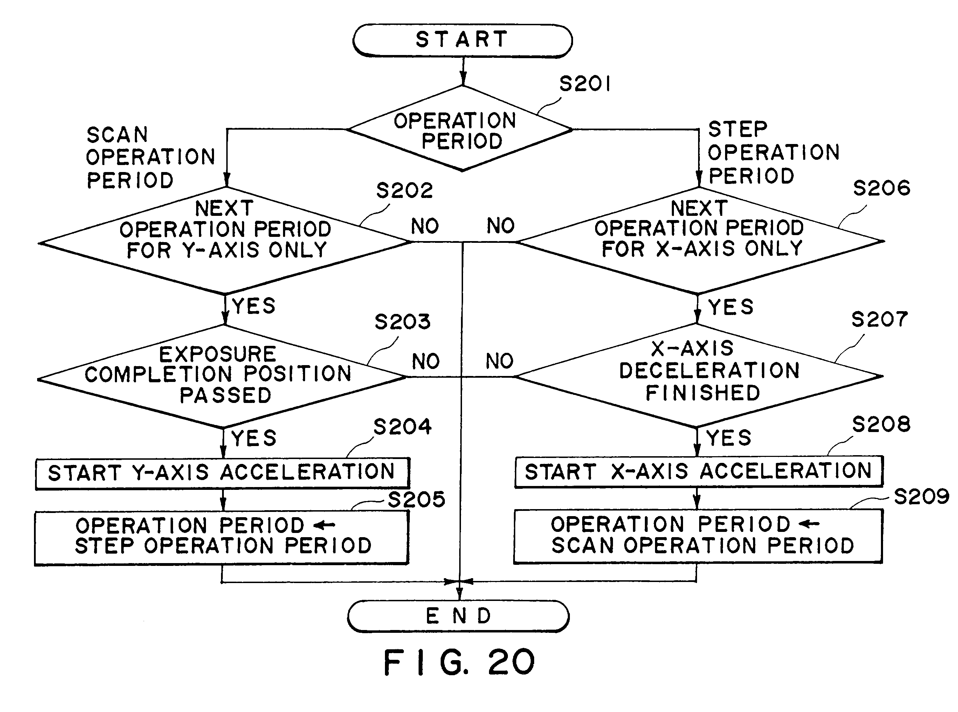

Figure 20 illustrates operation algorithm of the locus complementing means 5, in a further embodiment of the present invention. First, the locus complementing means 5 performs discrimination on the basis of the target position data stored in the storage means 1 as to: whether the current operation period is a scan operation period; whether only Y axis is in operation in the subsequent operation period; and whether the X-Y stage has passed an exposure completion position (steps S201 - S203). If the result of discrimination shows truth, in regard to the subsequent operation period the Y-axis position target generating means 3 is actuated to initiate Y-axis acceleration, and the procedure goes to the step operation period (steps S204 and S205). Also, the locus complementing means 5 performs discrimination as to: whether the current operation period is a step operation period; whether only X-axis is in operation in the subsequent operation period; and whether X-axis deceleration has completed (steps S206 - S207). If the result of discrimination shows truth, in regard to the subsequent operation period the X-axis position target generating means 2 is actuated to start X-axis acceleration, and the procedure goes to a scan operation period (steps S208 and S209). If the results of all discriminations show falsehood, drive is continued until the target position is reached and the current operation period is completed. If both axes are in operation in the current operation period, it is concluded that the X-Y stage has reached the target position, and drive for the axis is continued until the current operation period is completed.

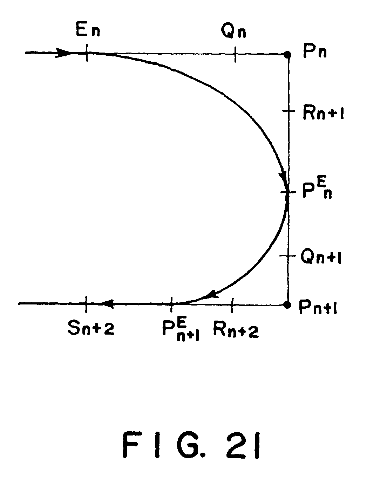

Viewing motion of a certain point on the X-Y stage 10 along the X-Y plane, the result may be such as illustrated in Figure 21. Reference characters in the drawing similar to those of Figure 18 represent corresponding positions. The X-Y stage 10 does not stop at $P_n$ but it passes inside the apical angel smoothly. This is effective to reduce the total time for step-and-scan procedure to the whole wafer surface, and to improve the throughput.

[Embodiment of Microdevice Manufacture]

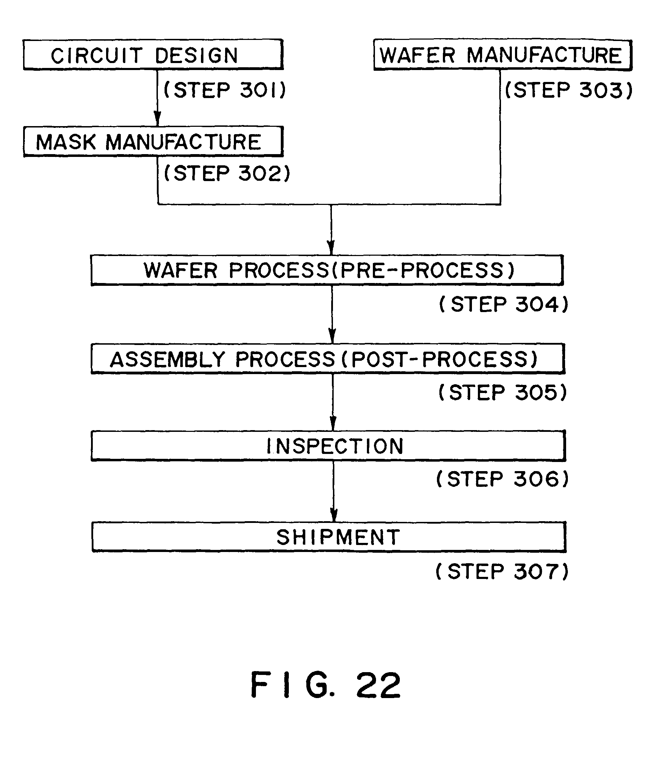

Figure 22 is a flow chart of procedure for manufacture of microdevices such as semiconductor chips (e.g. ICs or LSIs), liquid crystal panels, CCDs, magnetic heads or micro-machines, for example. Step 301 is a design process for designing a circuit of a semiconductor device. Step 302 is a process for making a mask on the basis of the circuit pattern design. Step 303 is a process for preparing a wafer by using a material such as silicon. Step 304 is a wafer process which is called a pre-process wherein, by using the so prepared mask and wafer, circuits are practically formed on the wafer through lithography. Step 305 subsequent to this is an assembling step which is called a post-process wherein the wafer having been processed by step 304 is formed into semiconductor chips. This step includes assembling (dicing and bonding) process and packaging (chip sealing) process. Step 306 is an inspection step wherein operation check, durability check and so on for the semiconductor devices provided by step 305, are carried out. With these processes, semiconductor devices are completed and they are shipped (step 307).

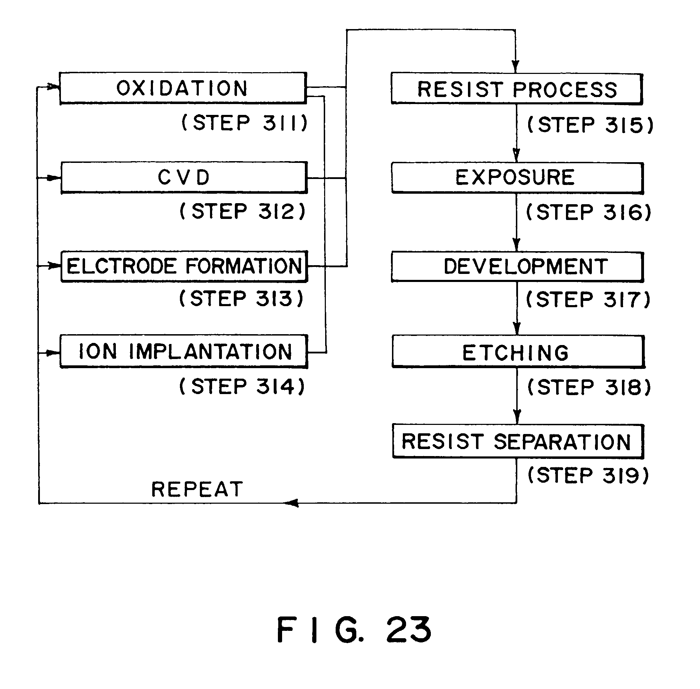

Figure 23 is a flow chart showing details of the wafer process. Step 311 is an oxidation process for oxidizing the surface of a wafer. Step 312 is a CVD process for forming an insulating film on the wafer surface. Step 313 is an electrode forming process for forming electrodes upon the wafer by vapor deposition. Step 314 is an ion implanting process for implanting ions to the wafer. Step 315 is a resist process for applying a resist (photosensitive material) to the wafer. Step 316 is an exposure process for printing, by exposure, the circuit pattern of the mask on the wafer through the exposure apparatus described above. Step 317 is a developing process for developing the exposed wafer. Step 318 is an etching process for removing portions other than the developed resist image. Step 319 is a resist separation process for separating the resist material remaining on the wafer after being subjected to the etching process. By repeating these processes, circuit patterns are superposedly formed on the wafer.

While the invention has been described with reference to the structures disclosed herein, it is not confined to the details set forth and this application is intended to cover such modifications or changes as may come within the purposes of the improvements or the scope of the following claims.

**Claims**

1. An exposure method wherein a pattern of a mask (102) is transferred to a plurality of different zones arranged on a wafer (108) by relative movement of a wafer illumination region (121) and the wafer (108), comprising the steps of:

    performing a scanning movement wherein the illumination region (121) moves in a first direction relative to the wafer across a first zone (120) of the wafer to transfer the mask pattern thereto; and
    performing a stepping movement wherein the illumination region (121) moves in a second direction relative to the wafer (108) from the first zone (120) to a second zone;

    characterised in that the movement of the illumination region (121) in the first or second direction is commenced before the preceding movement in the second or first direction respectively has stopped.

2. A method according to claim 1, wherein in the scanning movement, the mask (102) and the wafer (108) are scanningly moved independently at a predetermined speed ratio relative to a reduction projection optical system (111), and wherein, in the stepping movement, the wafer (108) is moved stepwise relative to the reduction optical system (111).

3. A method according to claim 1 or claim 2, wherein in the scanning movement both of the mask (102) and the wafer (108) are scanningly moved relative to a projection optical system (111) and the mask pattern is transferred on to one zone on the wafer.

4. A method according to claim 3, further comprising projection slit light on to the mask (102), scanningly moving the mask (102) and the wafer (108) in a timed relation and at a predetermined speed ratio, and projecting the mask pattern on to the wafer (108) in a reduced scale, whereby the mask pattern is transferred on to the wafer in a reduced scale.

5. A method according to any preceding claim, wherein, as scanning movement in the predetermined direction passes an exposure completion position, acceleration of a subsequent stepping movement in initiated.

**6.** A method according to any one of claims 1 to 4, wherein, after scanning movement in the predetermined direction passes an exposure completion position and before deceleration of the scanning movement is initiated, acceleration of a subsequent stepwise motion is initiated.

**7.** A method according to claim 1, wherein, when an n-th movement for the wafer comprises a scanning movement, an (n+1)-th movement comprises a stepping movement and an (n+2)-th movement comprises a scanning movement, acceleration in the (n+1)-th movement is initiated as an exposure completion position in the n-th movement is passed and an acceleration in the (n+2)-th movement is initiated after deceleration in the n-th movement is completed.

**8.** A method according to claim 7, wherein acceleration in the (n+2)-th movement is initiated before deceleration of stepping movement in the (n+1)-th movement is initiated.

**9.** A method according to any preceding claim, wherein the timing for initiation of a movement relative to an immediately preceding movement is variable.

**10.** A method according to claim 9, wherein the timing is variably set in accordance with at least one of target acceleration and jerk of the scanning movement or of the stepping movement, speed of constant-speed part of the scanning movement and acceleration stabilization time.

**11.** A method of manufacturing a semiconductor device comprising:

exposing a semiconductor wafer to illumination in an exposure method according to any preceding claim;
treating the exposed surface to form semiconductor component formations thereon;
and fabricating a semiconductor device from the exposed and treated wafer.

**12.** An exposure apparatus, comprising illumination means (110) for illuminating a predetermined illumination region on a mask (102), a mask stage (101) for holding the mask and for scanningly moving the same; a projection optical system (111) for projecting a pattern of the mask on to a wafer (108); a wafer stage (106) for holding the wafer (108) and for moving the same; and control means serviceable to perform step-and-scan operation wherein said mask stage (101) and said wafer stage (106) are scanningly moved in a timed relation and at a predetermined speed ratio to scanningly expose the wafer (108) to the pattern of the mask (102) and wherein said wafer stage (106) is moved stepwise to change a scanning exposure region on the wafer characterised in that:
said control means is operable in the step-and-scan operation such that, before one of the scanning movement or a stepping movement is stopped, the next stepping or scanning movement, is respectively, initiated.

**13.** An exposure apparatus according to claim 12, wherein said control means is operable to scanningly move the mask (108) and the wafer (102) relative to the projection optical system (111) so that the mask pattern is transferred onto one zone of the wafer.

**14.** An exposure apparatus according to claim 12 or claim 13, wherein said illumination means (110) is arranged to project slit light onto the mask (102) and including optical projection means (111) for projecting the mask pattern onto the wafer (108) in a reduced scale, whereby the mask pattern is transferred onto the wafer in the reduced scale.

**15.** An exposure apparatus according to any of claims 12 to 14, wherein said control means is operable as scanning movement in the predetermined direction passes an exposure completion position, to initiate acceleration of a subsequent stepping movement.

**16.** An exposure apparatus according to any of claims 12 to 14, wherein said control means is operable, after scanning movement in the predetermined direction passes an exposure completion position and before deceleration of the scanning movement is initiated, to initiate acceleration of a subsequent stepping movement

**17.** An exposure apparatus according to claim 11, wherein said control means is operable, when an n-th movement for the wafer (108) comprises a scanning movement motion period, an (n+1)-th movement comprises a stepping movement and an (n+2)-th movement comprises a scanning movement, to initiate acceleration in the (n+1)-th movement as an exposure completion position in the n-th movement is past, and to initiate acceleration in the (n+2)-th movement after deceleration in the n-th movement is completed.

**18.** An exposure apparatus according to claim 17 wherein said control means is operable to initiate acceleration in the (n+2)-th movement before deceleration of stepping movement in the (n+1)-th movement is initiated.

**19.** An exposure apparatus according to any of claims 12 to 18, including means for varying the timing for initiation of a movement relative to an immediately preceding movement.

**20.** An exposure apparatus according to claim 19 wherein said means for varying the timing is operable to variably set the initiation timing in accordance with at least one of target acceleration and jerk of the scanning movement or of the stepping movement, speed of a constant-speed part of the scanning movement, and acceleration stabilisation time.

## Patentansprüche

**1.** Belichtungsverfahren, wobei eine Struktur einer Maske (102) in eine Vielzahl von unterschiedlichen Zonen übertragen wird, die auf einem Wafer (108) angeordnet sind, durch die Relativbewegung eines Waferbeleuchtungsbereichs (121) und des Wafers (108), das die Schritte aufweist:

- Ausführen einer Abtastbewegung, wobei sich der Beleuchtungsbereich (121) in einer ersten Richtung in bezug auf den Wafer über eine erste Zone (120) des Wafers bewegt, um die Maskenstruktur darauf zu übertragen, und
- Ausführen einer Schrittbewegung, wobei sich der Beleuchtungsbereich (121) in einer zweiten Richtung in bezug auf den Wafer (108) aus der ersten Zone (120) in eine zweite Zone bewegt,

   **dadurch gekennzeichnet, daß** die Bewegung des Beleuchtungsbereichs (121) in der ersten oder der zweiten Richtung eingeleitet wird, bevor die vorhergehende Bewegung jeweils in der zweiten oder in der ersten Richtung zum Halt gekommen ist.

**2.** Verfahren gemäß Anspruch 1, wobei in der Abtastbewegung die Maske (102) und der Wafer (108) mit einer vorbestimmten Geschwindigkeit in bezug auf ein verkleinerndes optisches Projektionssystem (111) unabhängig abtastend bewegt werden und wobei in der Schrittbewegung der Wafer (108) in bezug auf das verkleinernde optische System (111) schrittweise bewegt wird.

**3.** Verfahren gemäß Anspruch 1 oder Anspruch 2, wobei in der Abtastbewegung sowohl die Maske (102) als auch der Wafer (108) relativ zu einem optischen Projektionssystem (111) abtastend bewegt werden und die Maskenstruktur in eine Zone auf dem Wafer übertragen wird.

**4.** Verfahren gemäß Anspruch 3, das ferner aufweist: Projizieren von Spaltlicht auf die Maske (102), abtastendes Bewegen der Maske (102) und des Wafers (108) in einer Zeitsteuerbeziehung und bei einem vorbestimmten Geschwindigkeitsverhältnis und Projizieren der Maskenstruktur auf den Wafer (108) in einem verkleinerten Maßstab, wodurch die Maskenstruktur in einem verkleinerten Maßstab auf den Wafer übertragen wird.

**5.** Verfahren gemäß einem der vorhergehenden Ansprüche, wobei dann, wenn die Abtastbewegung in der vorbestimmten Richtung eine Belichtungsabschlußposition durchläuft, die Beschleunigung einer nachfolgenden Schrittbewegung eingeleitet wird.

**6.** Verfahren gemäß einem der Ansprüche 1 bis 4, wobei dann, nachdem die Abtastbewegung in der vorbestimmten Richtung eine Belichtungsabschlußposition durchlaufen hat und bevor die Abbremsung der Abtastbewegung eingeleitet ist, die Beschleunigung einer nachfolgenden schrittweisen Bewegung eingeleitet wird.

**7.** Verfahren gemäß Anspruch 1, wobei dann, wenn eine n-te Bewegung für den Wafer eine Abtastbewegung aufweist, eine (n+1)-te Bewegung eine Schrittbewegung aufweist und eine (n+2)-te Bewegung eine Abtastbewegung aufweist, die Beschleunigung in der (n+1)-ten Bewegung eingeleitet wird, wenn eine Belichtungsabschlußposition in der n-ten Bewegung durchlaufen ist und eine Beschleunigung in der (n+2)-ten Bewegung eingeleitet wird, nachdem die Abbremsung in der n-ten Bewegung abgeschlossen ist.

**8.** Verfahren gemäß Anspruch 7, wobei die Beschleunigung in der (n+2)-ten Bewegung eingeleitet wird, bevor die Abbremsung der Schrittbewegung in der (n+1)-ten Bewegung eingeleitet ist.

9. Verfahren gemäß einem der vorhergehenden Ansprüche, wobei die Zeitsteuerung zur Einleitung einer Bewegung in bezug auf eine unmittelbar vorhergehende Bewegung veränderbar ist.

10. Verfahren gemäß Anspruch 9, wobei die Zeitsteuerung gemäß mindestens einer der Zielbeschleunigung und des Rucks der Abtastbewegung oder der Schrittbewegung, der Geschwindigkeit des Konstantgeschwindigkeitsteils der Abtastbewegung und der Beschleunigungsstabilisierungszeit veränderbar eingestellt wird.

11. Verfahren zur Herstellung einer Halbleitervorrichtung, das aufweist:

- Aussetzen eines Halbleiterwafers der Beleuchtung in einem Belichtungsverfahren gemäß einem der vorhergehenden Ansprüche,
- Behandeln der belichteten Oberfläche zum Erzeugen der Halbleiterkomponentenstrukturen auf dieser, und
- Herstellen einer Halbleitervorrichtung aus dem belichteten und behandelten Wafer.

12. Belichtungsvorrichtung, die aufweist: eine Beleuchtungsvorrichtung (110) zum Beleuchten eines vorbestimmten Beleuchtungsbereichs auf einer Maske (102), einen Maskentisch (101) zum Halten der Maske und zum abtastenden Bewegen derselben, ein optisches Projektionssystem (111) zum Projizieren einer Struktur der Maske auf einen Wafer (108), einen Wafertisch (106) zum Halten des Wafers (108) und zum Bewegen desselben und eine Steuervorrichtung, die dazu dient, die Step-und-Scan-Operation auszuführen, wobei der Maskentisch (101) und der Wafertisch (106) in einer zeitlichen Beziehung und in einem vorbestimmten Geschwindigkeitsverhältnis abtastend bewegt werden, um den Wafer (108) gemäß der Struktur der Maske (102) abtastend zu belichten, und wobei der Wafertisch (106) schrittweise bewegt wird, um einen Abtastbelichtungsbereich auf dem Wafer zu ändern,

    **dadurch gekennzeichnet, daß**:

    die Steuervorrichtung in der Step-und-Scan-Operation so betreibbar ist, daß bevor eine der Bewegungen, die Abtastbewegung oder eine Schrittbewegung, angehalten wird, jeweils die nächste Schritt- oder Abtastbewegung eingeleitet wird.

13. Belichtungsvorrichtung gemäß Anspruch 12, wobei die Steuervorrichtung betreibbar ist, um die Maske (108) und den Wafer (102) in bezug auf das optische Projektionssystem (111) abtastend zu bewegen, so daß die Maskenstruktur in eine Zone des Wafers übertragen wird.

14. Belichtungsvorrichtung gemäß Anspruch 12 oder Anspruch 13, wobei die Beleuchtungsvorrichtung (110) angeordnet ist, um Spaltlicht auf die Maske (102) zu projizieren, und eine optische Projektionsvorrichtung (111) zum Projizieren der Maskenstruktur auf den Wafer (108) in einem verkleinerten Maßstab aufweist, wodurch die Maskenstruktur in dem verkleinerten Maßstab auf den Wafer übertragen wird.

15. Belichtungsvorrichtung gemäß einem der Ansprüche 12 bis 14, wobei die Steuervorrichtung betreibbar ist, um dann, wenn die Abtastbewegung in der vorbestimmten Richtung eine Belichtungsabschlußposition durchläuft, die Beschleunigung einer nachfolgenden Schrittbewegung einzuleiten.

16. Belichtungsvorrichtung gemäß einem der Ansprüche 12 bis 14, wobei die Steuervorrichtung betreibbar ist, um nachdem die Abtastbewegung in der vorbestimmten Richtung eine Belichtungsabschlußposition durchlaufen hat und bevor die Abbremsung der Abtastbewegung eingeleitet ist, die Beschleunigung einer nachfolgenden Schrittbewegung einzuleiten.

17. Belichtungsvorrichtung gemäß Anspruch 11, wobei die Steuervorrichtung betreibbar ist, um dann, wenn eine n-te Bewegung für den Wafer (108) eine Abtastbewegungsperiode aufweist, eine (n+1)-te Bewegung eine Schrittbewegung aufweist und eine (n+2)-te Bewegung eine Abtastbewegung aufweist, um die Beschleunigung in der (n+1)-ten Bewegung einzuleiten, wenn eine Belichtungsabschlußposition in der n-ten Bewegung durchlaufen ist, und die Beschleunigung in der (n+2)-ten Bewegung einzuleiten, nachdem die Abbremsung in der n-ten Bewegung abgeschlossen ist.

18. Belichtungsvorrichtung gemäß Anspruch 17, wobei die Steuervorrichtung betreibbar ist, um die Beschleunigung in der (n+2)-ten Bewegung einzuleiten, bevor die Abbremsung der Schrittbewegung in der (n+1)-ten Bewegung eingeleitet wird.

19. Belichtungsvorrichtung gemäß einem der Ansprüche 12 bis 18, welche eine Vorrichtung zum Verändern der Zeitsteuerung für die Einleitung einer Bewegung in bezug auf eine unmittelbar vorhergehende Bewegung aufweist.

**20.** Belichtungsvorrichtung gemäß Anspruch 19, wobei die Vorrichtung zum Verändern der Zeitsteuerung betreibbar ist, um die Einleitungszeitsteuerung gemäß mindestens einer der Zielbeschleunigung und des Rucks der Abtastbewegung oder der Schrittbewegung, der Geschwindigkeit eines Konstantgeschwindigkeitsteils der Abtastbewegung und der Beschleunigungsstabilisierungszeit veränderbar einzustellen.

**Revendications**

**1.** Procédé d'exposition dans lequel un motif d'un masque (102) est transféré sur une pluralité de différentes zones agencées sur une tranche (108) par un mouvement relatif d'une région (121) d'illumination de tranche et de la tranche (108), comprenant les étapes dans lesquelles :

on exécute un mouvement de balayage dans lequel la région d'illumination (121) se déplace dans une première direction par rapport à la tranche à travers une première zone (120) de la tranche pour y transférer le motif du masque ; et
on exécute un mouvement pas à pas dans lequel la région d'illumination (121) se déplace dans une seconde direction par rapport à la tranche (108) de la première zone (120) à une seconde zone ;

caractérisé en ce que le mouvement de la région d'illumination (121) dans la première ou la seconde direction est amorcé avant que le mouvement précédent dans la seconde ou première direction, respectivement, se soit arrêté.

**2.** Procédé selon la revendication 1, dans lequel, dans le mouvement de balayage, le masque (102) et la tranche (108) sont animés d'un mouvement de balayage indépendamment à un rapport prédéterminé de vitesses par rapport à un système optique (111) de projection avec réduction, et dans lequel, dans le mouvement pas à pas, la tranche (108) est déplacée pas à pas par rapport au système optique (111) de réduction.

**3.** Procédé selon la revendication 1 ou la revendication 2, dans lequel, dans le mouvement de balayage, le masque (102) et la tranche (108) sont tous deux animés d'un mouvement de balayage par rapport à un système optique (111) de projection et le motif du masque est transféré sur une zone de la tranche.

**4.** Procédé selon la revendication 3, comprenant en outre la projection de lumière à travers une fente sur le masque (102), le déplacement en balayage du masque (102) et de la tranche (108) dans une relation de temps et à un rapport prédéterminé de vitesses, et la projection du motif du masque sur la tranche (108) à une échelle réduite, grâce à quoi le motif du masque est transféré sur la tranche à une échelle réduite.

**5.** Procédé selon l'une quelconque des revendications précédentes, dans lequel, pendant qu'un mouvement de balayage dans la direction prédéterminée passe par une position d'achèvement d'exposition, une accélération d'un mouvement pas à pas suivant est amorcée.

**6.** Procédé selon l'une quelconque des revendications 1 à 4, dans lequel, après qu'un mouvement de balayage dans la direction prédéterminée est passé par une position d'achèvement d'exposition et avant qu'une décélération du mouvement de balayage soit amorcée, une accélération d'un mouvement pas à pas suivant est amorcée.

**7.** Procédé selon la revendication 1, dans lequel, lorsqu'un nième mouvement pour la tranche comprend un mouvement de balayage, un (n+1)ième mouvement comprend un mouvement pas à pas et un (n+2)ième mouvement comprend un mouvement de balayage, une accélération dans le (n+1)ième mouvement est amorcée au moment où une position d'achèvement d'exposition dans le nième mouvement est franchie et une accélération dans le (n+2)ième mouvement est amorcée après qu'une décélération dans le nième mouvement a cessé.

**8.** Procédé selon la revendication 7, dans lequel une accélération dans le (n+2)ième mouvement est amorcée avant qu'une décélération du mouvement pas à pas dans le (n+1)ième mouvement soit amorcée.

**9.** Procédé selon l'une quelconque des revendications précédentes, dans lequel le temps pour amorcer un mouvement par rapport à un mouvement immédiatement précédent est variable.

**10.** Procédé selon la revendication 9, dans lequel le temps est établi de façon variable en fonction d'au moins une accélération de la cible et une secousse du mouvement de balayage ou du mouvement pas à pas, une vitesse d'une partie à vitesse constante du mouvement de balayage et un temps de stabilisation de l'accélération.

11. Procédé de fabrication d'un dispositif semiconducteur, comprenant :

l'exposition d'une tranche semiconductrice à une illumination dans un procédé d'exposition selon l'une quelconque des revendications précédentes ;
le traitement de la surface exposée pour former sur celle-ci des formations de composants semiconducteurs ;
et la fabrication d'un dispositif semiconducteur à partir de la tranche exposée et traitée.

12. Appareil d'exposition, comportant un moyen d'illumination (110) destiné à illuminer une région d'illumination prédéterminée sur un masque (102), une platine (101) de masque destiné à porter le masque et à l'animer d'un mouvement de balayage ; un système optique (111) de projection destiné à projeter un motif du masque sur une tranche (108) ; une platine (106) de tranche destinée à porter la tranche (108) et à la déplacer ; et un moyen de commande pouvant être mis en oeuvre pour effectuer une opération de pas-et-balayage dans laquelle ladite platine (101) du masque et ladite platine (106) de la tranche sont animées d'un mouvement de balayage dans une relation de temps et à un rapport prédéterminé de vitesses pour exposer par balayage la tranche (108) au motif du masque (108), et dans laquelle ladite platine (106) de la tranche est déplacée pas à pas pour modifier une région d'exposition de balayage sur la tranche, caractérisé en ce que :
ledit moyen de commande peut être mis en oeuvre dans l'opération de pas-et-balayage afin que, avant que l'un du mouvement de balayage ou du mouvement pas à pas soit arrêté, le mouvement suivant pas à pas ou de balayage, respectivement, soit amorcé.

13. Appareil d'exposition selon la revendication 12, dans lequel ledit moyen de commande peut être mis en oeuvre pour animer d'un mouvement de balayage le masque (108) et la tranche (102) par rapport au système optique (111) de projection afin que le motif du masque soit transféré sur une zone de la tranche.

14. Appareil d'exposition selon la revendication 12 ou la revendication 13, dans lequel ledit moyen d'illumination (110) est agencé de façon à projeter de la lumière à travers une fente sur le masque (102) et comprenant un moyen de projection optique (111) destiné à projeter le motif du masque sur la tranche (108) à une échelle réduite, grâce à quoi le motif du masque est transféré sur la tranche à l'échelle réduite.

15. Appareil d'exposition selon l'une quelconque des revendications 12 à 14, dans lequel ledit moyen de commande peut être mis en oeuvre au moment où un mouvement de balayage dans la direction prédéterminée passe par une position d'achèvement d'exposition, pour amorcer une accélération d'un mouvement pas à pas suivant.

16. Appareil d'exposition selon l'une quelconque des revendications 12 à 14, dans lequel ledit moyen de commande peut être mis en oeuvre, après qu'un mouvement de balayage dans la direction prédéterminée est passé par une position d'achèvement d'exposition et avant qu'une décélération du mouvement de balayage soit amorcée, pour amorcer une accélération d'un mouvement pas à pas suivant.

17. Appareil d'exposition selon la revendication 11, dans lequel ledit moyen de commande peut être mis en oeuvre, lorsqu'un nième mouvement pour la tranche (108) comprend une période de déplacement d'un mouvement de balayage, un (n+1)ième mouvement comprend un mouvement pas à pas et un (n+2)ième mouvement comprend un mouvement de balayage, pour amorcer une accélération dans le (n+1)ième mouvement au moment où une position d'achèvement d'exposition dans le nième mouvement est franchie, et pour amorcer une accélération dans le (n+2)ième mouvement après qu'une décélération dans le nième mouvement a cessé.

18. Appareil d'exposition selon la revendication 17, dans lequel ledit moyen de commande peut être mis en oeuvre pour amorcer une accélération dans le (n+2)ième mouvement avant qu'une décélération du mouvement pas à pas dans le (n+1)ième mouvement soit amorcée.

19. Appareil d'exposition selon l'une quelconque des revendications 12 à 18, comprenant un moyen pour faire varier le temps pour amorcer un mouvement par rapport à un mouvement immédiatement précédent.

20. Appareil d'exposition selon la revendication 19, dans lequel ledit moyen pour faire varier le temps peut être mis en oeuvre de façon à établir de manière variable le temps d'amorçage en fonction d'au moins une accélération visée et une secousse du mouvement de balayage ou du mouvement pas à pas, de la vitesse d'une partie à vitesse constante du mouvement de balayage, et d'un temps de stabilisation de l'accélération.

F I G. I

FIG. 2

EP 0 785 571 B1

**STORAGE MEANS** — 1

**POSITION TARGET GENERATING MEANS** — 4

**X-AXIS TARGET POSITION GENERATOR** — 2

**Y-AXIS TARGET POSITION GENERATOR** — 3

**LOCUS COMPLE-MENTING MEANS** — 5

**X-AXIS SERVO SYSTEM** — 6

**Y-AXIS SERVO SYSTEM** — 7

**X-STAGE** — 8

**Y-STAGE** — 9

**X-Y STAGE** — 10

F I G. 3

F I G. 4

EP 0 785 571 B1

F I G. 5

F I G. 6

18

EP 0 785 571 B1

FIG. 7

EP 0 785 571 B1

```
                    ┌─────────────────┐
                    │      START       │
                    └────────┬─────────┘
                             │
                            ╱ ╲                S11
                           ╱   ╲
          SCAN            ╱ OPERATION ╲            STEP
        OPERATION  ◄─────╱   PERIOD    ╲─────►   OPERATION
         PERIOD          ╲             ╱            PERIOD
                          ╲           ╱
                           ╲         ╱
                            ▼                              ▼
```

SCAN OPERATION PERIOD

STEP OPERATION PERIOD

S12 — NEXT OPERATION PERIOD FOR Y-AXIS ONLY — NO — NO — NEXT OPERATION PERIOD FOR X-AXIS ONLY — S15

YES

YES

S13 — EXPOSURE COMPLETION POSITION PASSED — NO — NO — START Y-AXIS DECELERATION — S16

YES

YES

S14 — START Y-AXIS ACCELERATION

S17 — START X-AXIS ACCELERATION

END

# FIG. 8

EP 0 785 571 B1

# F I G. 9

# F I G. 10

21

F I G. II

F I G. 12

EP 0 785 571 B1

START

S111 — TARGET ACCELERATION IN STEP OPERATION PERIOD

a1 < a → S112 — COMPLEMENTING MEANS ← ALGORISM A1

a0 < a < a1 → S113 — COMPLEMENTING MEANS ← ALGORISM A2

a < a0 → S114 — COMPLEMENTING MEANS ← ALGORISM A3

END

FIG. 13

START

SCAN OPERATION PERIOD

STEP OPERATION PERIOD

S125 — OPERATION PERIOD

S126 — NEXT OPERATION PERIOD FOR Y-AXIS ONLY — YES / NO

S130 — X-AXIS DECELERATION FINISHED — YES / NO

S127 — EXPOSURE COMPLETION POSITION PASSED — YES / NO

S131 — REGULATED — YES / NO

S128 — START Y-AXIS ACCELERATION

S132 — START X-AXIS ACCELERATION

S129 — OPERATION PERIOD → STEP OPERATION PERIOD

S133 — OPERATION PERIOD → SCAN OPERATION PERIOD

END

F I G. 14

EP 0 785 571 B1

```
                    ┌─────────────────┐
                    │     START       │
                    └─────────────────┘
                             │
                             ▼
                        ╱─────────╲         S135
                       ╱ OPERATION ╲
                      ╱   PERIOD    ╲
     SCAN    ◄───────╲             ╱───────►  STEP
   OPERATION          ╲           ╱          OPERATION
    PERIOD             ╲─────────╱            PERIOD
        │                                        │
        ▼              S136                      ▼             S140
    ╱───────────╲                            ╱───────────╲
   ╱    NEXT     ╲      NO      NO          ╱    NEXT     ╲
  ╱ OPERATION PERIOD╲────────┬────────────╱ OPERATION PERIOD╲
   ╲ FOR Y-AXIS ONLY╱         │            ╲ FOR X-AXIS ONLY ╱
    ╲─────────────╱           │             ╲─────────────╱
        │ YES                 │                 │ YES
        ▼         S137        │                 ▼            S141
    ╱───────────╲             │             ╱───────────╲
   ╱  EXPOSURE   ╲    NO       │     NO     ╱   Y-AXIS    ╲
  ╱ COMPLETION POSITION╲──────┼───────────╱  DECELERATION ╲
   ╲    PASSED    ╱            │            ╲   STARTED    ╱
    ╲───────────╱             │             ╲───────────╱
        │ YES      S138       │                 │ YES       S142
        ▼                     │                 ▼
  ┌─────────────────────┐     │       ┌─────────────────────┐
  │ START Y-AXIS        │     │       │ START X-AXIS        │
  │ ACCELERATION        │     │       │ ACCELERATION        │
  └─────────────────────┘     │       └─────────────────────┘
        │         S139        │                 │           S143
        ▼                     │                 ▼
  ┌─────────────────────┐     │       ┌─────────────────────┐
  │ OPERATION PERIOD ◄  │     │       │ OPERATION PERIOD ◄  │
  │ STEP OPERATION PERIOD│    │       │ SCAN OPERATION PERIOD│
  └─────────────────────┘     │       └─────────────────────┘
        │                     │                 │
        └─────────────────────┼─────────────────┘
                              ▼
                    ┌─────────────────┐
                    │      END        │
                    └─────────────────┘
```

F I G. 15

START

S145

OPERATION
PERIOD

SCAN
OPERATION
PERIOD

STEP
OPERATION
PERIOD

S146

NEXT
OPERATION PERIOD
FOR Y-AXIS ONLY

NO

NO

S151

NEXT
OPERATION AXIS FOR
X-AXIS ONLY

YES

S147

YES

S152

EXPOSURE
COMPLETION POSITION
PASSED

NO

NO

X-AXIS
DECELERATION
FINISHED

YES

S148

S153

YES

STAND-BY FOR
X-AXIS
ACCELERATION
START

START Y-AXIS ACCELERATION

STEP
OPERATION MODE

S149

STAND-BY FOR
X-AXIS
DECELERATION
END

OPERATION PERIOD ←
STEP OPERATION PERIOD

S150

S154

X-AXIS
DECELERATION
FINISHED

STEP OPERATION MODE ←
STAND-BY FOR X-AXIS
DECELERATION END

NO

YES

FIG. 16A

FIG. 16A

FIG. 16B

FIG. 16

EP 0 785 571 B1

EP 0 785 571 B1

S155 — OVER HALF OF STEP WIDTH

NO

YES

S159 — X-AXIS ACCELERATION START POSITION REACHED

NO

YES

S158 — STEP OPERATION MODE ← STAND-BY FOR X-AXIS ACCELERATION START

S156 — START X-AXIS ACCELERATION

S157 — OPERATION PERIOD ← SCAN OPERATION PERIOD

S160 — START X-AXIS ACCELERATION

S161 — OPERATION PERIOD ← SCAN OPERATION PERIOD

END

F I G. 16B

F I G. 17

F I G. 18

F I G. 19

FIG. 20

START

S201 — OPERATION PERIOD

SCAN OPERATION PERIOD

STEP OPERATION PERIOD

S202 — NEXT OPERATION PERIOD FOR Y-AXIS ONLY / NO / YES

S206 — NEXT OPERATION PERIOD FOR X-AXIS ONLY / NO / YES

S203 — EXPOSURE COMPLETION POSITION PASSED / NO / YES

S207 — X-AXIS DECELERATION FINISHED / NO / YES

S204 — START Y-AXIS ACCELERATION

S208 — START X-AXIS ACCELERATION

S205 — OPERATION PERIOD → STEP OPERATION PERIOD

S209 — OPERATION PERIOD → SCAN OPERATION PERIOD

END

FIG. 21

CIRCUIT DESIGN
(STEP 301)

WAFER MANUFACTURE
(STEP 303)

MASK MANUFACTURE
(STEP 302)

WAFER PROCESS(PRE-PROCESS)
(STEP 304)

ASSEMBLY PROCESS(POST-PROCESS)
(STEP 305)

INSPECTION
(STEP 306)

SHIPMENT
(STEP 307)

# FIG. 22

OXIDATION

(STEP 311)

CVD

(STEP 312)

ELCTRODE FORMATION

(STEP 313)

ION IMPLANTATION

(STEP 314)

RESIST PROCESS

(STEP 315)

EXPOSURE

(STEP 316)

DEVELOPMENT

(STEP 317)

ETCHING

(STEP 318)

RESIST SEPARATION

(STEP 319)

REPEAT

F I G. 23